# EUROPÄISCHE PATENTSCHRIFT

(11) **EP 1 849 892 B1**
(45) Veröffentlichungstag und Bekanntmachung des Hinweises auf die Patenterteilung: **27.05.2015**
(21) Anmeldenummer: 07007144.4
(22) Anmeldetag: 05.04.2007
(51) Int. Cl.: C30B 11/00, F27B 14/14, H05B 6/36

(54) **Ofen für Nichtmetall-Schmelzen**
Furnace for non ferrous metal smelting
Four pour fusion d'éléments non métallique

(30) Priorität: 27.04.2006 DE 102006020234
(43) Veröffentlichungstag der Anmeldung: 31.10.2007
(73) Patentinhaber: SolarWorld Industries Sachsen GmbH, 09599 Freiberg (DE)
(72) Erfinder: Dietrich, Marc, 09603 Großschirma (DE); Freudenberg, Bernhard, 96450 Coburg (DE); Müller, Armin, 09599 Freiberg (DE); Seidel, Jens, 09599 Freiberg (DE); Stenzenberger, Josef, 09599 Freiberg (DE)
(74) Vertreter: Rau, Albrecht

(56) Entgegenhaltungen:
- EP-A- 1 072 696
- DE-A1- 10 339 402
- DE-A1- 10 349 339

## Beschreibung

Die Erfindung betrifft einen Ofen für Nichtmetall-Schmelzen und ein Verfahren zum Betreiben desselben.

Aus der DE 103 49 339 A1 ist eine Kristallzüchtungsanlage bekannt. Diese weist eine runde Kokille auf, die von einem zylinderförmigen Spulen-Mantel umgeben ist. Dieser Ofen erzeugt in mehrerlei Hinsicht verbesserungswürdiges Silizium. Aus der EP 0 889 148 A1 ist eine Anlage mit rechteckiger Kokille bekannt.

Der Erfindung liegt die Aufgabe zugrunde, einen Ofen für Nichtmetall-Schmelzen zu schaffen, der für die Weiterverarbeitung möglichst geeignete Nichtmetall-Blöcke erzeugen kann.

Die Aufgabe wird durch die Merkmale der unabhängigen Ansprüche 1 und 12 gelöst. Der Kern der Erfindung besteht darin, die bei einer elektrischen Heiz-Einrichtung ohnehin vorhandene Leitungen zur Erzeugung eines zeitlich-veränderlichen Magnetfeldes in der Nichtmetall-Schmelze zu nutzen. Hierfür muss an die Leitungen ein zeitlich-veränderlicher Strom angelegt werden. Durch das zeitlich-veränderliche Magnetfeld entstehen Konvektionen in der Nichtmetall-Schmelze, die die Verteilung von Fremdatomen vergleichmäßigen.

Weitere vorteilhafte Ausgestaltungen ergeben sich aus den Unteransprüchen.

Zusätzliche Merkmale und Einzelheiten der Erfindung ergeben sich aus der Beschreibung mehrerer Ausfiihrungsbeispiele anhand der Zeichnung. Es zeigen
- Fig. 1: eine Ansicht eines Ofens gemäß einem ersten Ausfiihrungsbeispiel,
- Fig. 2: einen Schnitt gemäß der Schnittlinie II-II in Fig. 1,
- Fig. 3: einen Schnitt gemäß der Schnittlinie III-III in Fig. 1,
- Fig. 4: einen Schnitt gemäß der Schnittlinie IV-IV in Fig. 1,
- Fig. 5: eine Ansicht eines Ofens gemäß einem zweiten Ausführungsbeispiel,
- Fig. 6: einen Schnitt gemäß der Schnittlinie VI-VI in Fig. 5,
- Fig. 7: einen Schnitt gemäß der Schnittlinie VII-VII in Fig. 5,
- Fig. 8: eine Heiz-Einrichtung gemäß einem dritten Ausfiihrungsbeispiel,
- Fig. 9: eine Heiz-Einrichtung gemäß einem vierten Ausfiihrungsbeispiel,
- Fig. 10: eine Heiz-Einrichtung gemäß einem fünften Ausfiihrungsbeispiel,
- Fig. 11: eine Heiz-Einrichtung gemäß einem sechsten Ausfiihrungsbeispiel,
- Fig. 12: eine Heiz-Einrichtung gemäß einem siebten Ausfiihrungsbeispiel, und
- Fig. 13: eine Heiz-Einrichtung gemäß einem achten Ausführungsbeispiel.

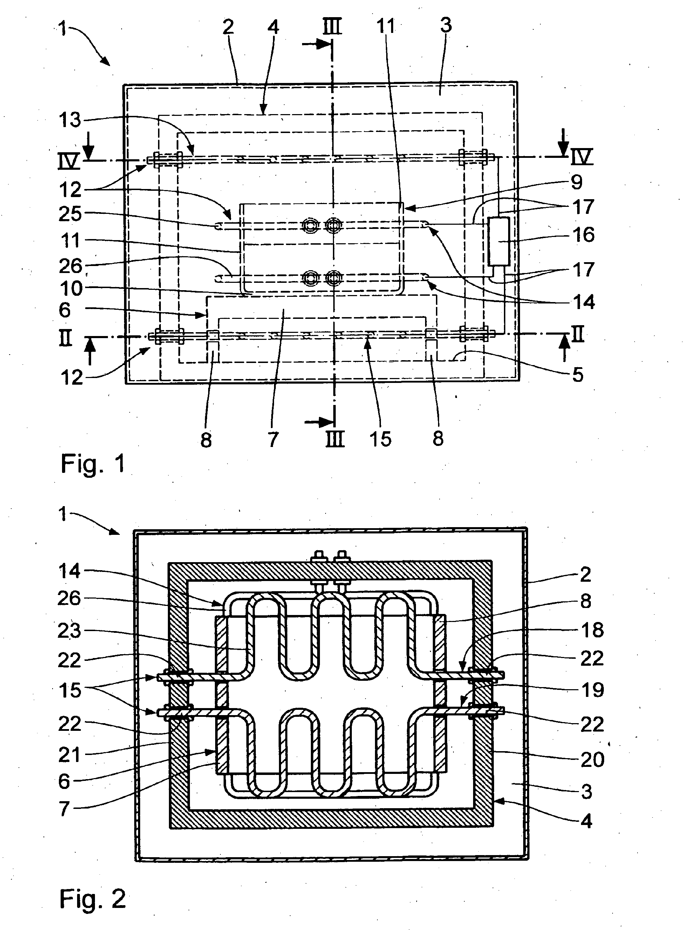

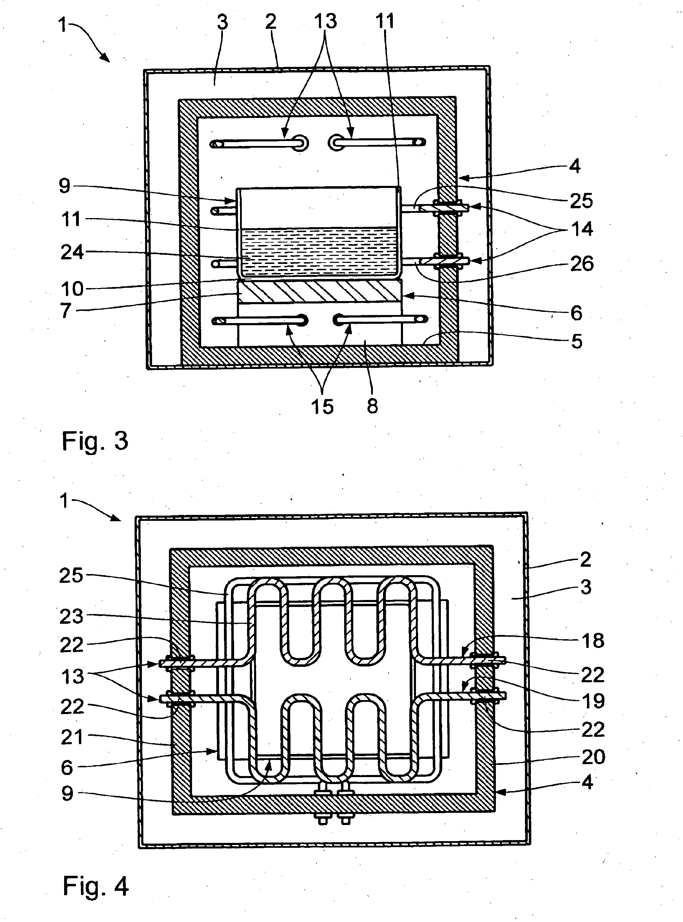

Im Folgenden wird unter Bezugnahme auf die Fig. 1 bis 4 ein erstes Ausführungsbeispiel der Erfindung beschrieben. Ein Ofen 1 dient dem Schmelzen und/oder gerichteten Erstarren von Nichtmetallen, insbesondere Silizium. Dies bedeutet, dass in dem Ofen 1 sowohl Rohsilizium eingeschmolzen als auch bereits außerhalb geschmolzenes Silizium kontrolliert abgekühlt werden kann. Der Ofen 1 weist ein im Wesentlichen quaderförmiges Gehäuse 2 auf, das als Stahlkessel ausgebildet ist. Bei dem Gehäuse 2 handelt es sich um einen Druckbehälter, der beim Betrieb des Ofens 1 evakuiert wird, um Verunreinigungen der Silizium-Schmelze 24 durch Sauerstoff und andere Gase zu vermeiden. Das Gehäuse 2 umschließt einen GehäuseInnenraum 3. In dem Innenraum 3 ist eine quaderförmige Grafit-Isolation 4 angeordnet. Innerhalb der Grafit-Isolation 4 ist ein auf dem Boden 5 der Isolation 4 abgestützter Ständer 6 angeordnet. Dieser weist eine horizontale Tragplatte 7 sowie von dieser nach unten vorspringende, auf dem Boden 5 abgestützte Seitenwände 8 auf. Auf der Tragplatte 7 ist mindestens eine quaderförmige, im Querschnitt rechteckige Kokille 9 abgestützt. Diese weist einen Kokillen-Boden 10 sowie vier zueinander paarweise parallele, sich vom Boden 10 nach oben erstreckende Seitenwände 11 auf. Es können mehrere Kokillen 9, beispielsweise zwei, vier, sechs oder acht Kokillen, in dem Ofen 1 angeordnet sein. Der Vorteil von im Querschnitt rechteckigen Kokillen 9 ist, dass mehrere nebeneinander platzsparend angeordnet werden können, besser als dies beispielsweise mit runden Kokillen möglich ist. Die Kokille 9 ist je nach dem Betriebszustand des Ofens 1 mit zu schmelzendem Silizium, geschmolzenem Silizium 24 oder erstarrter Silizium-Schmelze gefüllt. Unter dem Begriff Kokille wird sowohl ein zur einmaligen Nutzung bestimmtes Gefäß verstanden, das anschließend zerstört ist bzw. zerstört wird. Darunter wird auch ein häufig als Tiegel bezeichnetes mehrfach nutzbares Gefäß verstanden.

Der Ofen 1 weist eine elektrische Heiz-Einrichtung 12 bestehend aus einer oberhalb der Kokille 9 angeordneten Deckenheiz-Einrichtung 13, einer die Kokille 9 umfangsseitig umgebenden Seitenheiz-Einrichtung 14 und einer unterhalb der Kokille 9 angeordneten Bodenheiz-Einrichtung 15 auf, wobei nicht alle Einrichtungen 13, 14, 15 gleichzeitig präsent sein müssen. Die Heiz-Einrichtung 12 umgibt die Kokille 9 zumindest teilweise, d. h. sie ist zumindest darüber und/oder darunter und/oder seitlich der Kokille 9 angeordnet. Die Einrichtungen 13, 14 und 15 sind mit einer nur in Fig. 1 und dort auch nur schematisch dargestellten Stromversorgungs-Einrichtung 16 über elektrische Zuführ-Leitungen 17 verbunden. Die Deckenheiz-Einrichtung 13 weist zwei voneinander getrennte Leitungen 18, 19 auf, die von außen durch eine Seitenwand 20 der Grafit-Isolation 4 geführt sind und durch die gegenüberliegende Seitenwand 21 der Grafit-Isolation 4 wieder nach außen geführt sind. Die Leitungen 18, 19 sind an beiden Enden mit der Stromversorgungs-Einrichtung 16 elektrisch leitend verbunden. Wenn in der Anmeldung von Leitungen die Rede ist, so sind solche gemeint, die zur Führung der entsprechenden Heiz-Ströme geeignet sind. Da diese Ströme bei mehreren tausend Ampere liegen können, handelt es sich bei den Leitungen in der Regel um massive Bänder oder Stangen, die vorzugsweise aus einem gut stromleitenden Material bestehen. Die eigentlichen Heiz-Leitungen enthalten vorzugsweise Kohlenstoff und/oder Molybdän und/oder Wolfram. Die Zufuhr-Abschnitte im kühleren Bereich können Kupfer und/oder Aluminium und/oder kohlenstoffbasierte Werkstoffe enthalten. Die Leitungen 18, 19 weisen jeweils durch die Seitenwände 20, 21 verlaufende Zuführ-Abschnitte 22 sowie dazwischen liegende Mäander-Abschnitte 23 auf. Die Mäander-Abschnitte 23 sind spiegelsymmetrisch zueinander angeordnet. Die Schleifen des Mäander-Abschnitts 23 verlaufen horizontal. Die unterhalb der Kokille 9 angeordnete, durch den Ständer 6 verlaufende Bodenheiz-Einrichtung 15 ist im vorliegenden Fall wie die Deckenheiz-Einrichtung 13 ausgebildet.

Die Seitenheiz-Einrichtung 14 weist zwei übereinander angeordnete, die Kokille 9 umfangsseitig umgebende Leitungs-Schleifen 25, 26 auf.

Die Schleifen 25, 26 folgen im Wesentlichen der rechteckigen Außenkontur der Kokille 9 und sind insofern abgesehen von den Zuführ-Abschnitten 22 im Wesentlichen rechteckig. Die durch die Grafit-Isolation 4 gefiihrten Zuführ-Abschnitte der Bodenheiz-Einrichtung 15 bzw. Deckenheiz-Einrichtung 13 einerseits sowie der Seitenheiz-Einrichtung 14 sind um 90° bezüglich einer vertikalen Achse gegeneinander versetzt, wie dies in Fig. 2 dargestellt ist.

Im Folgenden wird beschrieben, wie der Ofen 1 betrieben wird. Die Kokille 9 ist mit Silizium gefüllt. Der Innenraum des Ofens 1 ist evakuiert. Der Innenraum kann auch mit Schutzgas, wie zum Beispiel Argon, gefüllt sein. Die Stromversorgungs-Einrichtung 16 versorgt die Heiz-Einrichtung 12 mit elektrischem Strom I(t). Der zeitlich-veränderliche Strom I(t) kann vorzugsweise aus einer Gleichstromkomponente I_{DC} und einer Wechselstromkomponente I_{AC}(t) bestehen, sodass gilt: I(t) = I_{DC} + I_{AC}(t). Bei der Wechselstromkomponente I_{AC}(t) kann es sich um normalen sinusförmigen Wechselstrom handeln. Es sind auch andere zeitlich-veränderliche Ströme, wie zum Beispiel Sägezahn- oder Rechteckstrom, möglich. Die Wechselstromkomponente I_{AC}(t) weist eine Frequenz von 0,1 Hz bis 1000 Hz, insbesondere 1 bis 500 Hz, insbesondere 10 bis 300 Hz, insbesondere 75 Hz bis 250 Hz auf. Es kann auch bei ca. 50 Hz gearbeitet werden. Der Wechselstromanteil I_{AC}(t) liegt ca. zwischen 100 und 5000 Amperewindungen. Der Gleichstromanteil I_{DC} kann zwischen 0 und 5000 Amperewindungen liegen. Die Stromanteile werden in der Einheit "Amperewindung" angegeben, die eigentlich eine Einheit der magnetischen Durchflutung ist, die von einem Strom von 1 Ampere in einer einzelnen Leiterschleife hervorgerufen wird. Bei mehreren Leiterschleifen wird der Strom mit der Anzahl der Windungen multipliziert. Die Angabe der "Amperewindung" ist insofern aussagekräftiger als die Angabe der Ströme in den einzelnen Schleifen, da letztendlich die Zahl der Leiterschleifen, beispielsweise bei der Seitenheiz-Einrichtung 14 frei gewählt werden kann. Die verschiedenen Heiz-Einrichtungen 13, 14 und 15 können alle in Phase oder mit einem entsprechenden Phasenversatz, insbesondere von 60° oder 120°, betrieben werden. Mit den verschiedenen Heiz-Einrichtungen 13, 14 und 15 können auch Wanderfelder erzeugt werden.

Bei dem vorliegenden Ausführungsbeispiel beträgt die Phasenverschiebung zwischen den beiden Schleifen 25, 26 0°. Die Phasenverschiebung des Stroms durch die Bodenheiz-Einrichtung 15 und Deckenheiz-Einrichtung 13 einerseits und Seitenheiz-Einrichtung 14 andererseits beträgt +60°. Die konkret verwendete Frequenz beträgt 50 Hz. Die Phasenverschiebung φ ist zwischen einem Vergleichsstrom I_{V}(t) und einem Bezugs-Strom I_{B}(t) wie folgt definiert: Angenommen, der Bezugs-Strom ließe sich darstellen als I_{B}(t) = I_{B0} sin (2 n f t), so besitzt der Vergleichsstrom eine Phasenverschiebung φ, wenn er sich darstellen lässt als
Iv(t) = I_{V0} sin (2 π f t + 2 π φ /360°). Hierbei ist f die Frequenz und φ die Phasenverschiebung.

Im Folgenden ist anhand einer Grafik dargestellt, wie der Wechselstromanteil I_{AC}(t) die Qualität der multikristallinen Silizium(mc-Si)-Blöcke erhöht.

| | | | | |
|---|---|---|---|---|
| Anteil Wechselstrom am Gesamtstrom in % | 0% | 50% | 50% | 100% |
| Frequenz des Wechselstromes in Hz | - | 8 Hz | 17 Hz | 50 Hz |
| Stromstärke durch Deckenheiz-Einrichtung in A | 800 | 1000-1100 | 1000-1100 | 800-900 |
| Stromstärke durch Seitenheiz-Einrichtung insgesamt in Amperewindungen | 800 | 1500-1600 | 1500-1600 | 1000-1100 |
| Stromstärke durch Bodenheiz-Einrichtung in A | 0 | 130-270 | 130-270 | 0-200 |
| Maß für die Ausbeute an Gutmaterial aus den mc-Si-Blöcken (je höher die Zahl desto höher die Ausbeute) | 1 | 2 | 2 | 3 |

Durch das Anlegen eines zeitlich veränderlichen Stromes an die Heiz-Einrichtung 12 werden in der Silizium-Schmelze 24 zeitlich-veränderliche Magnetfelder erzeugt, die zu einer erhöhten Konvektion der Schmelze 24 führen. Es ist möglich, dass hierdurch eine homogenere Durchmischung der Schmelze 24 und damit ein verringerter Einbau von Fremdatomen in das multikristalline Silizium erreicht wird. Die Heiz-Einrichtung 12 kann auch zum Heizen vorgesehene - im Betrieb heiße - Leitungen zum Heizen der Schmelze, beispielsweise durch Gleichstrom, und weitere - im Betrieb kalte - Leitungen zur Erzeugung des magnetischen Wechselfeldes aufweisen. In diesem Fall wären die elektrische Heizung und die Erzeugung der Magnetfelder voneinander entkoppelt.

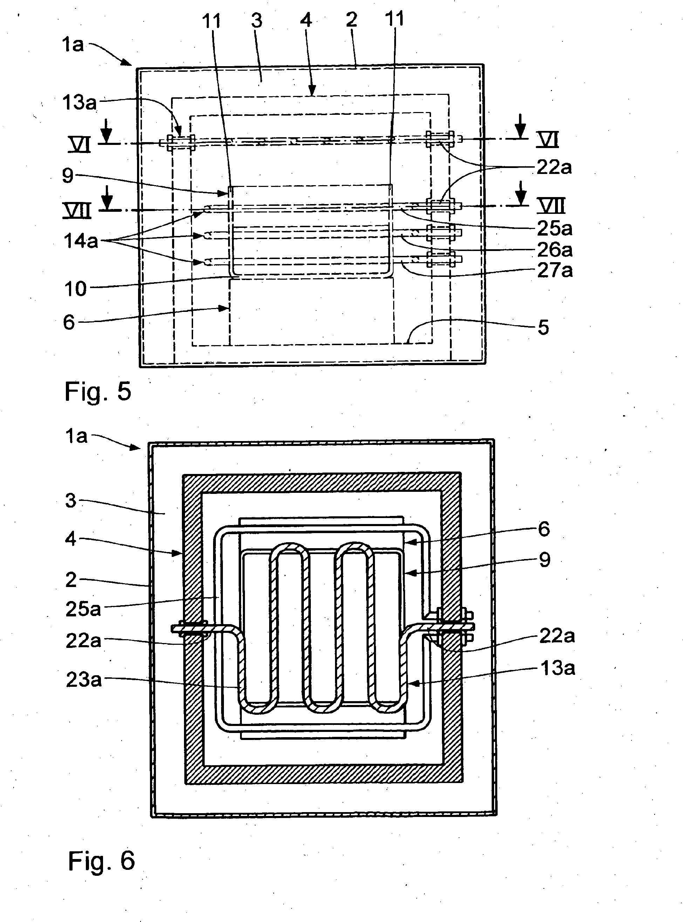

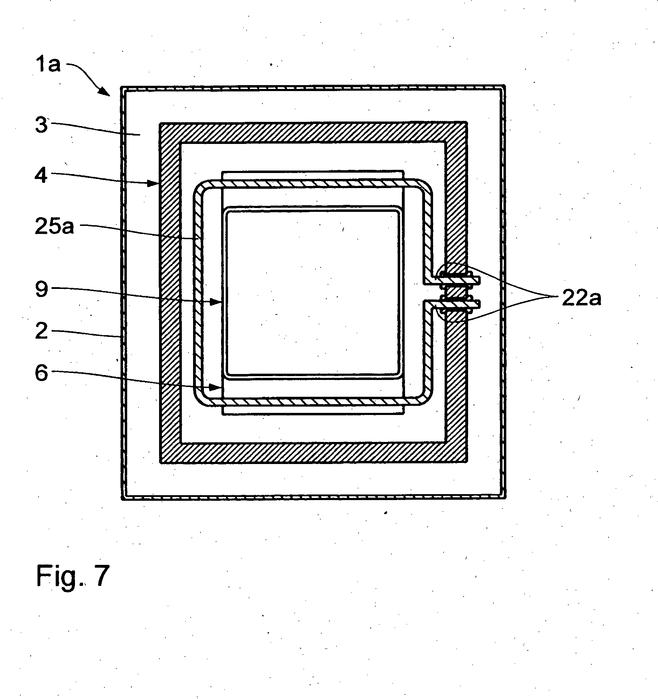

Im Folgenden wird unter Bezugnahme auf die Fig. 5 bis 7 ein zweites Ausführungsbeispiel der Erfindung beschrieben. Konstruktiv identische Teile erhalten dieselben Bezugszeichen wie beim ersten Ausführungsbeispiel, auf dessen Beschreibung hiermit verwiesen wird. Konstruktiv unterschiedliche, jedoch funktionell gleichartige Teile erhalten dieselben Bezugszeichen mit einem nachgestellten a. Der wesentliche Unterschied gegenüber dem ersten Ausführungsbeispiel besteht darin, dass die Kokille 9 umfangsseitig von drei übereinander angeordneten, im Querschnitt rechteckigen, bis auf die Zuführ-Abschnitte 22a geschlossene Schleifen 25a, 26a, 27a umgeben ist, die die Seitenheiz-Einrichtung 14a bilden. Die Bodenheiz-Einrichtung fehlt. Oberhalb der Kokille 9 befindet sich eine Deckenheiz-Einrichtung 13a, die aus einer Leitung bestehend aus einem Zuführ-Abschnitt 22a, einem Mäander-Abschnitt 23a und einem gegenüberliegenden Zufuhr-Abschnitt 22a besteht, wobei die Abschnitte 22a durch die Wände der Grafit-Isolation 4 geführt sind. Die Schleifen des Mäander-Abschnitts 23a verlaufen horizontal und somit parallel zur Oberfläche der Silizium-Schmelze 24. Die Heiz-Einrichtungen 13a, 14a werden mit einem Wechselstrom mit einer Frequenz von 50 Hz betrieben, wobei aber auch andere Frequenzen möglich sind. In der nachfolgenden Tabelle sind die Phasenverschiebung der Heizströme, der Heizstrom sowie die relevanten Ausbeuten dargestellt.

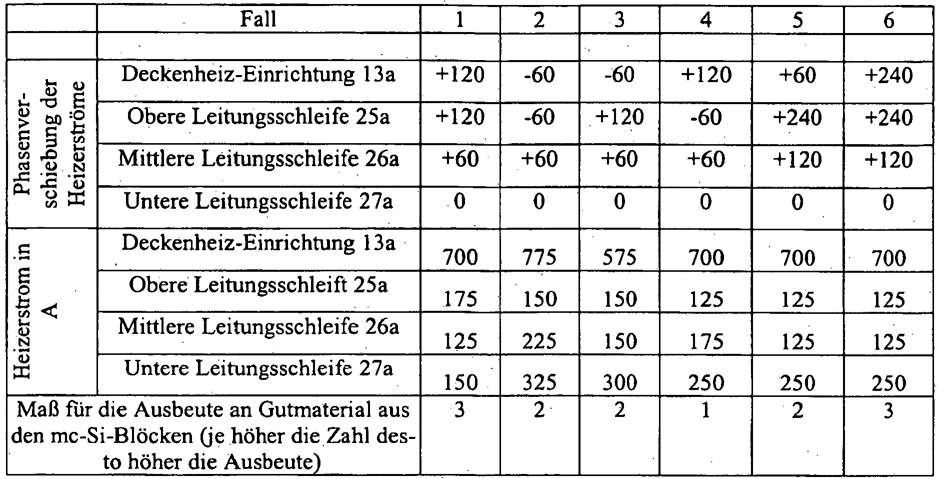

Es zeigt sich, dass die höchste Ausbeute erhalten wird, wenn an die Schleifen 25a, 26a und 27a ein Wanderfeld, insbesondere Strom mit einer Phasenverschiebung von +60° bzw. +120°, angelegt wird und wenn die Deckenheiz-Einrichtung 13a in Phase mit dem Strom in der oberen Leitungs-Schleife 25a betrieben wird.

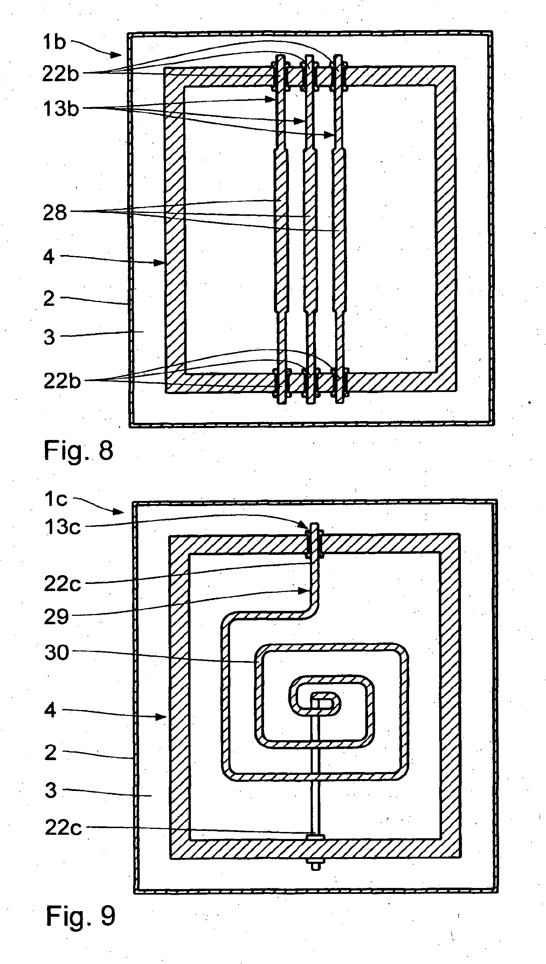

Im Folgenden wird unter Bezugnahme auf Fig. 8 ein drittes Ausfiihrungsbeispiel der Erfindung beschrieben. Identische Teile erhalten dieselben Bezugszeichen wie beim ersten Ausführungsbeispiel. Konstruktiv unterschiedliche, jedoch funktionell gleichartige Teile erhalten dieselben Bezugszeichen mit einem nachgestellten b. Fig. 8 zeigt exemplarisch den Aufbau einer der Heiz-Einrichtungen 13b, 14b und/oder 15b bestehend aus drei parallel zueinander verlaufenden Heiz-Stäben 28, die durch gegenüberliegende Seitenwände der Grafit-Isolation 4 geführt sind. Die Heizstäbe 28 werden bevorzugt mit Strömen versorgt, die derart phasenverschoben sind, dass ein Wanderfeld entsteht. Bevorzugt sind Phasenverschiebungen von +60° oder +120°. Die Anordnung gemäß Fig. 8 kann an den vier Seitenwänden 11 der Kokille 9, darüber und/oder darunter angeordnet sein. Es können auch mehr oder weniger als drei nebeneinander angeordnete Heizstäbe 28 Verwendung finden. Darüber hinaus muss die Zahl der Heizstäbe 28 an den verschiedenen Seiten der Kokille 9, insbesondere umfangsseitig einerseits sowie darüber und darunter andererseits nicht gleich sein.

Im Folgenden wird unter Bezugnahme auf Fig. 9 ein viertes Ausfuhrungsbeispiel der Erfindung beschrieben. Identische Teile erhalten dieselben Bezugszeichen wie beim ersten Ausführungsbeispiel. Konstruktiv unterschiedliche, jedoch funktionell gleichartige Teile erhalten dieselben Bezugszeichen mit einem nachgestellten c. Der wesentliche Unterschied gegenüber dem Ausführungsbeispiel gemäß Fig. 8 besteht darin, dass eine spiralförmige Heizleitung 29 bestehend aus Zuführabschnitten 22c und einem Spiral-Abschnitt 30 vorgesehen ist. Der Spiral-Abschnitt 30 weist rechteckige Seiten mit abnehmenden Seitenlängen auf, die parallel zu den Wänden der Grafit-Isolation 4 verlaufen. Einer der Zuführ-Abschnitte 22c ist mit der Mitte der Spirale verbunden und hinter den Spiral-Abschnitten 30 nach außen geführt. Die in Fig. 9 dargestellte Anordnung kann an den Umfangsseiten der Kokille 9 und/oder darüber und/oder darunter angeordnet sein.

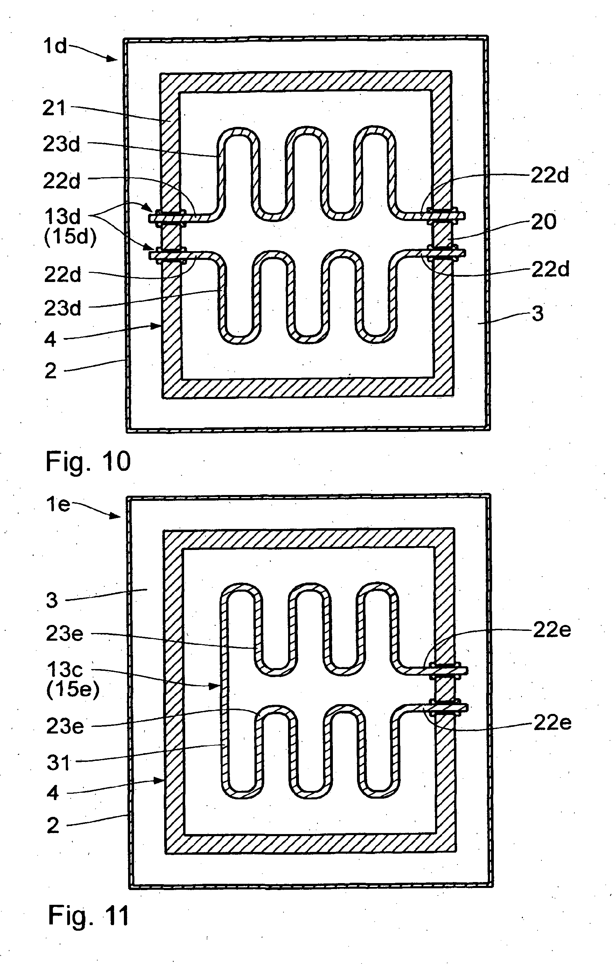

Im Folgenden wird unter Bezugnahme auf Fig. 10 ein fünftes Ausführungsbeispiel der Erfindung beschrieben. Identische Teile erhalten dieselben Bezugszeichen wie beim ersten Ausfiihrungsbeispiel. Konstruktiv unterschiedliche, jedoch funktionell gleichartige Teile erhalten dieselben Bezugszeichen mit einem nachgestellten d. Das Ausführungsbeispiel gemäß Fig. 10 zeigt eine Deckenheiz- und/oder Seitenheiz- und/oder Bodenheiz-Geometrie, die dem ersten Ausführungsbeispiel entspricht. Es können auch nur ein Mäander oder drei Mäander oder noch mehrere Mäander nebeneinander angeordnet sein.

Im Folgenden wird unter Bezugnahme auf Fig. 11 ein sechstes Ausführungsbeispiel der Erfindung beschrieben. Identische Teile erhalten dieselben Bezugszeichen wie beim ersten Ausführungsbeispiel. Konstruktiv unterschiedliche, jedoch funktionell gleichartige Teile erhalten dieselben Bezugszeichen mit einem nachgestellten e. Fig. 11 zeigt mögliche Bodenheizund/oder Seitenheiz- und/oder Deckenheiz-Geometrien. Die Heizleitung weist wie in Fig. 10 zueinander parallele Zuführ-Abschnitte 22e auf, an die sich zueinander spiegelsymmetrische Mäander-Abschnitte 23e anschließen, die am in Fig. 11 linken Ende über einen Verbindungs-Abschnitt 31 miteinander verbunden sind. Somit bildet Fig. 11 nur einen Stromkreis, wohingegen Fig. 10 zwei Stromkreise bildet.

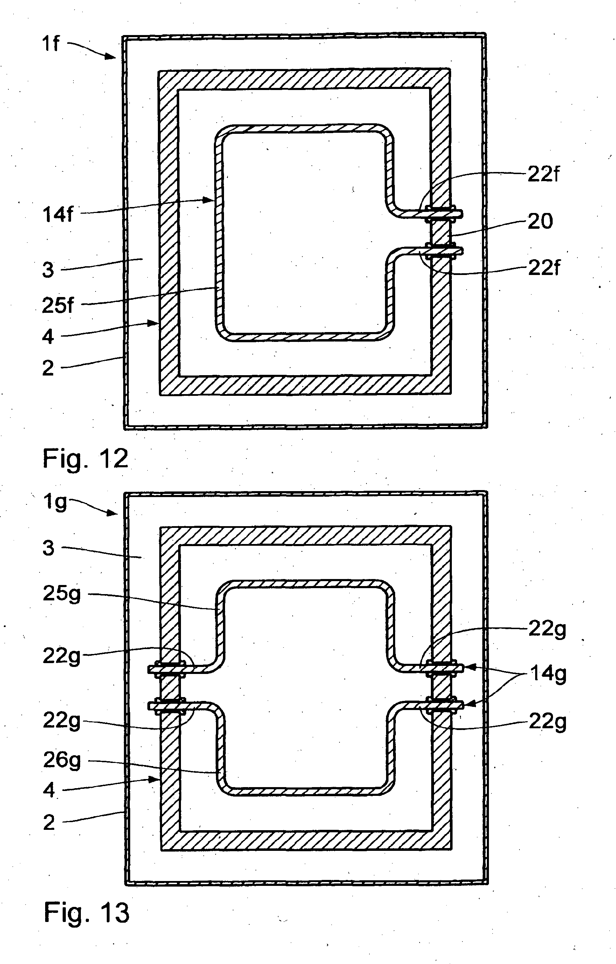

Im Folgenden wird unter Bezugnahme auf Fig. 12 ein siebtes Ausführungsbeispiel der Erfindung beschrieben. Identische Teile erhalten dieselben Bezugszeichen wie beim ersten Ausführungsbeispiel. Konstruktiv unterschiedliche, jedoch funktionell gleichartige Teile erhalten dieselben Bezugszeichen mit einem nachgestellten f. Fig. 12 zeigt eine Seitenheiz-Geometrie, die bereits im zweiten Ausführungsbeispiel beschrieben worden ist. Es ist somit eine die Kokille 9 umgebende Leitungs-Schleife 25f mit im Wesentlichen rechteckiger Form und zueinander parallelen ZuführAbschnitten 22f vorgesehen.

Im Folgenden wird unter Bezugnahme auf Fig. 13 ein achtes Ausführungbeispiel der Erfindung beschrieben. Identische Teile erhalten dieselben Bezugszeichen wie beim ersten Ausführungsbeispiel. Konstruktiv unterschiedliche, jedoch funktionell gleichartige Teile erhalten dieselben Bezugszeichen mit einem nachgestellten g. Die Seitenheiz-Geometrie entspricht im Wesentlichen dem ersten Ausfiihrungsbeispiel, wonach zwei Leitungen die Kokille 9 bügelartig umgeben. Es sind jeweils zueinander parallele Zuführ-Abschnitte 22g vorgesehen, die in rechteckige bügelförmige Leitungs-Schleifen 25g bzw. 26g übergehen.

Die in den zuvor beschriebenen Ausfiihrungsbeispielen dargestellten Heiz-Einrichtungs-Geometrien können im Wesentlichen frei miteinander kömbiniert werden, beispielsweise kann eine Boden- bzw. Deckenheiz-Einrichtung gemäß Fig. 11 und eine Seitenheiz-Einrichtung gemäß Fig. 12 vorgesehen sein. Darüber hinaus können grundsätzlich auch Boden- und Deckenheiz-Einrichtung voneinander verschieden sein oder, wie beim zweiten Ausführungsbeispiel, zum Teil fehlen. Darüber hinaus können übereinander mehrere voneinander verschiedene Heizleitungen, beispielsweise wie in den Fig. 12 und 13, übereinander vorgesehen sein, die gemeinsam die Seitenheiz-Einrichtung bilden.

## Patentansprüche

1. Ofen für Nichtmetall-Schmelzen, insbesondere Silizium-Schmelzen, mit
a. einem einen Innenraum (3) umschließenden Gehäuse (2),
b. mindestens einer, in dem Innenraum (3) angeordneten Kokille (9) zur Aufnahme einer Nichtmetall-Schmelze (24),
c. mindestens einer, die mindestens eine Kokille (9) zumindest teilweise umgebenden, elektrischen Heiz-Einrichtung (12) zur Beeinflussung der Temperatur der Nichtmetall-Schmelze (24), und
d. einer, mit der mindestens einen Heiz-Einrichtung (12) elektrisch leitend verbundenen Stromversorgungs-Einrichtung (16) zur Versorgung der Heiz-Einrichtung (12) mit einem zeitlichveränderlichen Strom I(t), wobei
der Strom I(t) eine Größe besitzt, die zur Einstellung einer vorbestimmten Temperatur der Nichtmetall-Schmelze (24) geeignet ist,
e. die mindestens eine Kokille (9) im Querschnitt rechteckig ist.
**dadurch gekennzeichnet, dass** der Strom I(t) eine Frequenz von 0,1 Hz bis 1000 Hz aufweist.

2. Ofen gemäß Anspruch 1, **dadurch gekennzeichnet, dass** die Heiz-Einrichtung (12) eine die mindestens eine Kokille (9) umfangsseitig umgebende Seitenheiz-Einrichtung (14; 14a; 14b; 14c; 14f; 14g) aufweist.

3. Ofen gemäß Anspruch 1 oder 2, **dadurch gekennzeichnet, dass** die Heiz-Einrichtung (12) eine oberhalb der mindestens einen Kokille (9) angeordnete Deckenheiz-Einrichtung (13; 13a; 13b; 13d; 13e) und/oder eine unterhalb der mindestens einen Kokille (9) angeordnete Bodenheiz-Einrichtung (15; 15d; 15e) aufweist.

4. Ofen gemäß einem der vorangehenden Ansprüche, **dadurch gekennzeichnet, dass** der Strom I(t) eine Frequenz aufweist von 1 Hz bis 500 Hz, insbesondere 10 Hz bis 300 Hz, insbesondere ungefähr 75 Hz bis 250 Hz.

5. Ofen gemäß einem der vorangehenden Ansprüche, **dadurch gekennzeichnet, dass** der Strom I(t) zusammengesetzt ist aus einer Gleichstromkomponente I_{DC} und einer Wechselstromkomponente I_{AC}(t).

6. Ofen gemäß einem der vorangehenden Ansprüche, **dadurch gekennzeichnet, dass** die Heiz-Einrichtung (12) mehrere voneinander getrennte Stromkreise aufweist, die von phasenverschobenem Strom, insbesondere mit einer Phasenverschiebung von n · 60°, n = 1, 2, 3 ..., durchflossen werden.

7. Ofen gemäß Anspruch 3, **dadurch gekennzeichnet, dass** die Deckenheiz-Einrichtung (13; 13a; 13b; 13d; 13e) mäanderförmige Leitungen aufweist.

8. Ofen gemäß Anspruch 3, **dadurch gekennzeichnet, dass** die Heiz-Einrichtung (12) mindestens eine spiralförmige Leitung (30) aufweist.

9. Ofen gemäß Anspruch 5, **dadurch gekennzeichnet, dass** die Gleichstromkomponente ID_{DC} zwischen 0 und 1000 Amperewindungen und/oder die Wechselstromkomponente I_{AC}(t bis 10 bis 5000 Amperewindungen liegt.

10. Ofen gemäß einem der vorangehenden Ansprüche, **dadurch gekennzeichnet, dass** er der Herstellung von multikristallinern Silizium dient.

11. Ofen gemäß einem der vorangehenden Ansprüche, **dadurch gekennzeichnet, dass** mehrere Kokillen (9) in dem Ofen angeordnet sein können.

12. Verfahren zum Schmelzen von Nichtmetallen und/oder Erstarren von Nichtmetall-Schmelzen umfassend die folgenden Schritte:
- Bereitstellen eines Ofens gemäß einem der vorangehenden Ansprüche;
- Anlegen eines zeitlich veränderlichen Stromes I(t),
- Erzeugen eines zeitlich veränderlichen Magnetfeldes in der Nichtmetall-Schmelze (24).

13. Verfahren gemäß dem vorhergehenden Anspruch, **dadurch gekennzeichnet, dass** mit den Heiz-Einrichtungen (13, 14, 15) Wanderfelder erzeugt werden.

## Claims

1. Oven for non-metal melts, in particular for silicon melts, with
a. a housing (2) enclosing an interior (3),
b. at least one mould (9) arranged in the interior (3) for receiving a non-metal melt (24),
c. at least one electrical heating device (12) enclosing at least partially the at least one mould (9) for influencing the temperature of the non-metal melt (24), and
d. a power supply device (16) coupled in an electrically conductive manner to the at least one heating device (12) for supplying the heating device (12) with a time-variable current I(t), wherein the current I(t) is of a magnitude suitable for setting a predetermined temperature of the non-metal melt (24),
e. the at least one mould (9) is rectangular in cross-section, **characterised in that** the current I(t) has a frequency in the range of 0.1 Hz to 1000 Hz.

2. Oven according to claim 1, **characterised in that** the heating device (12) has a side heating device (14; 14a; 14b; 14c; 14f; 14g) enclosing the circumferential face the at least one mould (9).

3. Oven according to claim 1 or 2, **characterised in that** the heating device (12) has an overhead heating device (13; 13a; 13b; 13d; 13e) arranged above the at least one mould (9) and/or a floor heating device (15; 15d; 15e) arranged below the at least one mould (9).

4. Oven according to any one of the preceding claims, **characterised in that** the current I(t) has a frequency in the range of 1 Hz to 500 Hz, in particular 10 Hz to 300 Hz, in particular approximately 75 Hz to 250 Hz.

5. Oven according to any one of the preceding claims, **characterised in that** the current I(t) is composed of a direct current component I_{DC} and an alternating current component I_{AC}(t).

6. Oven according to any one of the preceding claims, **characterised in that** the heating device (12) has a plurality of separate electrical circuits through which phase-shifted current flows, in particular with a phase shift of n · 60°, wherein n = 1, 2, 3....

7. Oven according to claim 3, **characterised in that** the overhead heating device (13; 13a; 13b; 13d; 13e) has meander-shaped lines.

8. Oven according to claim 3, **characterised in that** the heating device (12) has at least one spiral-shaped line (30).

9. Oven according to claim 5, **characterised in that** the direct current component I_{DC} lies at between 0 and 1000 ampere-turns and/or the alternating current component I_{AC}(t) lies at 10 to 5000 ampere-turns.

10. Oven according to any one of the preceding claims, **characterised in that** it is used for the production of polycrystalline silicon.

11. Oven according to any one of the preceding claims, **characterised in that** a plurality of moulds (9) may be arranged in the oven.

12. Method for melting non-metals and/or solidifying non-metal melts comprising the following steps:
a) providing an oven according to any one of the preceding claims,
b) applying a time-variable current I(t),
c generating a time-variable magnetic field in the non-metal melt (24).

13. Method according to the preceding claim, **characterised in that** travelling fields are generated with the heating devices (13, 14, 14).

## Revendications

1. Four pour fusion d'éléments non métalliques, notamment la fusion de silicium, comprenant
a. une enceinte (2) entourant une partie interne (3),
b. au moins une coquille (9) disposée dans la partie interne (3), pour la réception d'un élément non métallique fondu (24),
c. au moins un système de chauffage (12) électrique entourant au moins partiellement la au moins une coquille (9) pour agir sur la température de l'élément non métallique fondu (24) et
d. un système d'alimentation électrique (16) relié de manière conductrice électriquement avec au moins un système de chauffage (12) pour l'alimentation du système de chauffage (12) par un courant I(t) variable dans le temps, où
le courant I(t) a une valeur qui est appropriée pour le réglage d'une température prédéfinie de l'élément non métallique fondu (24),
la au moins une coquille (9) est rectangulaire dans la section transversale,
**caractérisé en ce que**
le courant I(t) possède une fréquence de 0,1 Hz à 1000 Hz.

2. Four selon la revendication 1, **caractérisé en ce que** le système de chauffage (12) présente au moins un système de chauffage latéral (14 ; 14a ; 14b ; 14c ; 14f ; 14g) entourant la au moins une coquille (9) sur le pourtour.

3. Four selon les revendications 1 ou 2, **caractérisé en ce que** le système de chauffage (12) présente un système de chauffage supérieur (13 ; 13a ; 13b ; 13d ; 13e) disposé au dessus de la au moins une coquille (9) et/ou un système de chauffage inférieur (15 ; 15d ; 15e) disposé en dessous de la au moins une coquille (9).

4. Four selon l'une des revendications précédentes, **caractérisé en ce que** le courant I(t) possède une fréquence entre 1 Hz et 500 Hz, notamment entre 10 Hz et 300 Hz, en particulier, d'environ 75 Hz à 250 Hz.

5. Four selon l'une des revendications précédentes, **caractérisé en ce que** le courant I(t) est composé d'une composante de courant continue I_{DC} et d'une composante de courant alternatif I_{AC} (t).

6. Four selon l'une des revendications précédentes, **caractérisé en ce que** le système de chauffage (12) présente plusieurs circuits de courant séparés les uns des autres qui sont parcourus par un courant déphasé, notamment avec un déphasage de n · 60 °, n = 1, 2, 3....

7. Four selon la revendication 3, **caractérisé en ce que** le système de chauffage supérieur (13 ; 13a ; 13b ; 13d ; 13e) présente des conduites en forme de méandres.

8. Four selon la revendication 3, **caractérisé en ce que** le système de chauffage (12) présente au moins une conduite (30) en forme de spirale.

9. Four selon la revendication 5, **caractérisé en ce que** la composante de courant continu I_{DC} se situe entre 0 et 1000 ampère-tour et/ou la composante de courant alternatif I_{AC} (t) se situe entre 10 et 5000 ampère-tour.

10. Four selon l'une des revendications précédentes, **caractérisé en ce qu'**il sert à la fabrication de silicium multi cristallin.

11. Four selon l'une des revendications précédentes, **caractérisé en ce que** plusieurs coquilles (9) peuvent être disposées dans le four.

12. Procédé pour la fusion d'éléments non métalliques, et/ou pour la solidification d'éléments non métalliques fondus, comprenant les étapes suivantes :
- mise au point d'un four selon les revendications précédentes ;
- mise en place d'un courant I(t) variable dans le temps,
- création d'un champ magnétique variable dans le temps dans l'élément non métallique fondu (24).

13. Procédé selon la revendication précédente, **caractérisé en ce que** des champs glissants sont générés avec les systèmes de chauffage (13, 14, 15).
